# EUROPÄISCHE PATENTSCHRIFT

(11) **EP 1 801 894 B1**
(45) Veröffentlichungstag und Bekanntmachung des Hinweises auf die Patenterteilung: **22.04.2009**
(21) Anmeldenummer: 05028439.7
(22) Anmeldetag: 23.12.2005
(51) Int. Cl.: H01L 41/24

(54) **Verfahren zum Herstellen eines piezoelektrischen Bauteils**
Method for producing a piezoelectric device
Méthode de fabrication d'un composant piézo-électrique

(43) Veröffentlichungstag der Anmeldung: 27.06.2007
(73) Patentinhaber: Delphi Technologies, Inc., Troy, MI 48007 (US)
(72) Erfinder: Sciortino, Giacomo G., 49076 Osnabrück (DE); Goat, Christopher A., North Meadow, Offham, Kent (GB)
(74) Vertreter: Gregory, John David Charles

(56) Entgegenhaltungen:
- EP-A- 1 107 325
- WO-A-03/105247
- PATENT ABSTRACTS OF JAPAN Bd. 2003, Nr. 05, 12. Mai 2003 (2003-05-12) -& JP 2003 008092 A (JAPAN SCIENCE & TECHNOLOGY CORP), 10. Januar 2003 (2003-01-10)
- PATENT ABSTRACTS OF JAPAN Bd. 010, Nr. 164 (E-410), 11. Juni 1986 (1986-06-11) -& JP 61 015382 A (NEC CORP), 23. Januar 1986 (1986-01-23)
- PATENT ABSTRACTS OF JAPAN Bd. 1995, Nr. 04, 31. Mai 1995 (1995-05-31) -& JP 07 007193 A (TOKIN CORP), 10. Januar 1995 (1995-01-10)
- "Borosilikatglas" WIKIPEDIA, [Online] 24. Januar 2005 (2005-01-24), XP002382986 Gefunden im Internet: URL:http://de.wikipedia.org/wiki/Borosilik atglas> [gefunden am 2006-05-30]

## Beschreibung

Die vorliegende Erfindung betrifft ein Verfahren zum Herstellen eines piezoelektrischen Bauteils, insbesondere eines Piezoaktors, mit wenigstens einer Außenfläche und umfassend einen Mehrschichtaufbau aus wenigstens einer piezoelektrischen Keramikschicht und wenigstens zwei Elektroden.

Bekannte Piezoaktoren weisen üblicherweise einen Stapel alternierender (Innen)elektroden und Piezokeramikschichten auf, wobei die einzelnen Innenelektroden beidseitig von jeweils einer Piezokeramikschicht und die einzelnen Piezokeramikschichten, ausgenommen der am Rand des Stapels angeordneten, beidseitig von jeweils einer Innenelektrode umgeben sind. Dabei weisen jeweils benachbarte, durch eine Piezokeramikschicht voneinander getrennte Innenelektroden eine unterschiedliche Polarität auf, beispielsweise die erste, dritte und fünfte Innenelektrode des Stapels eine positive Polarität und die zweite, vierte und sechste Innenelektrode des Stapels eine negative Polarität, so dass bei Anlegen einer elektrischen Spannung zwischen jeweils zwei benachbarten Innenelektroden jeweils ein elektrisches Feld ausbildet wird. Dies wird konstruktiv beispielsweise dadurch erreicht, dass jeweils ein Ende jeder zweiten Innenelektrode mit einer als erste Außenelektrode fungierenden und an einer ersten Seitenfläche des in der Regel quaderförmigen Piezoaktors aufgebrachten Metallschicht elektrisch leitend verbunden ist, während sich jeweils ein Ende der anderen Innenelektroden mit einer auf einer zweiten, der ersten gegenüberliegenden Seitenfläche des Piezoaktors aufgebrachten und als zweite Außenelektrode fungierenden Metallschicht in Kontakt befindet. Durch Anlegen einer elektrischen Spannung an diese beiden Außenelektroden werden somit die einzelnen Innenelektroden alternierend polarisiert, so dass jede einzelne Piezokeramikschicht, welche zwischen zwei Innenelektroden unterschiedlicher Polarität angeordnet ist, einem elektrischen Feld ausgesetzt ist. Durch die stapelförmige Anordnung der einzelnen Piezokeramikschichten und der Innenelektrodenschichten wird eine Vervielfältigung der nutzbaren Längenausdehnung der Einzelschichten erreicht, so dass in Abhängigkeit von der Anzahl an Piezokeramikschichten Stellwege bis zu 500 µm erreicht werden können.

Um bei der vorgenannten Anordnung der Innenelektroden bei Anlegung einer elektrischen Spannung einen elektrischen Kurzschluss zu vermeiden, müssen die einzelnen Innen- und Außenelektroden unterschiedlicher Polarität voneinander elektrisch isoliert werden. Um einen Kurzschluss zwischen den Innenelektroden einer ersten Polarität und der Außenelektrode entgegengesetzter Polarität zu vermeiden, erstrecken sich die einzelnen Innenelektroden üblicherweise nicht über die gesamte Breite der von den beiden mit je einer Außenelektrode versehenen Seitenflächen begrenzten Querschnittsebene, sondern ausgehend von der Seitenfläche, welche die Außenelektrode gleicher Polarität aufweist, mit der die Innenelektrode verbunden ist, nur bis zu einem gewissen Abstand zu der gegenüberliegenden Seitenfläche, auf der die zweite Außenelektrode entgegengesetzter Polarität angeordnet ist. Dadurch bildet sich an den beiden jeweils mit einer Außenelektrode versehenen Seitenflächen jeweils ein sich axial erstreckender Randbereich aus, in dem sich jeweils nur Innenelektroden einer Polarität befinden. In diesen Randbereichen wird bei Anlegen einer elektrischen Spannung zwischen den Außenelektroden mithin kein elektrisches Feld erzeugt, so dass diese Randschichten piezoelektrisch inaktiv sind.

Um diese piezoelektrisch inaktiven Bereiche auf die axialen Randbereiche der beiden Seitenflächen mit daran angeordneter Außenelektrode zu beschränken, erstrecken sich die einzelnen Innenelektroden in der Querrichtung dazu, das heißt von einer Seitenwand ohne Außenelektrode zu der dazu gegenüberliegenden Seitenwand, durchgehend, so dass sich die einzelnen Innenelektroden bis zu den beiden Oberflächen der Seitenflächen des Piezoaktors, welche keine Außenelektrode aufweisen, erstrecken und dort freiliegen. Um an diesen Seitenflächen einen elektrische Kurzschluss zwischen benachbarten Elektroden unterschiedlicher Polarität zu vermeiden, werden diese beiden Seitenflächen üblicherweise mit einer flexiblen dielektrischen Beschichtung aus geeignetem Passivierungsmaterial versehen, wobei für diesen Zweck beispielsweise Beschichtungen aus SilikonGummi oder aus Fluorpolymeren eingesetzt werden.

Allerdings sind die Isolierungseigenschaften der bekannten Passivierungsmaterialien nicht für alle Anwendungen von Piezoaktoren ausreichend. Bei dem Einsatz von Piezoaktoren zum Öffnen und Schließen von Einspritzventilen in Dieselmotoren beispielsweise sind die piezoelektrischen Bauteile Temperaturen von bis zu 150°C sowie Einspritzdrücken von 200 bis 2.000 bar ausgesetzt. Die für diesen Zweck eingesetzten Passivierungsmaterialien, beispielsweise Fluorpolymere, besitzen zwar eine vergleichsweise geringe Treibstoff- und Feuchtigkeitsdurchlässigkeit, sind jedoch gleichwohl weder für Treibstoff noch für Feuchtigkeit vollständig undurchlässig. Insbesondere wenn der Feuchtigkeitsgehalt des Treibstoffs mehr als 200 ppm beträgt, besteht bei den bekannten Passivierungsmaterialien die Gefahr, dass Feuchtigkeit durch die Passivierungsschicht diffundiert und insbesondere an den Seitenflächen, an denen benachbarte Elektroden unterschiedlicher Polarität freiliegen, einen elektrischen Kurzschluss hervorruft.

Aus der JP 2003-008,092 ist ein Piezoaktor umfassend piezoelektrische Keramiken und Innenelektroden bekannt, bei dem im Wesentlichen die gesamte Seitenfläche des Piezoaktors mit einem Glass beschichtet ist, um die Feuchtigkeitsbeständigkeit und die Lebensdauer des Piezoaktors zu erhöhen. Zur Herstellung dieses Piezoaktors wird zunächst ein Grundkörper aus einem Mehrschichtaufbau aus mehreren piezoelektrischen Keramikschichten und Elektroden, wobei die einzelnen piezoelektrischen Keramikschichten und die einzelnen Elektroden in Form eines Stapels alternierend übereinanderliegend angeordnet sind, bereitgestellt, bevor dieser Grundkörper gesintert und anschließend mit Außenelektroden versehen wird, bevor schließlich eine Glasspaste auf die Seitenfläche des Bauteils aufgetragen und getrocknet wird.

In der EP 1 107 325 A2 wird ein Verfahren zur Herstellung eines piezoelektrischen Bauteils offenbart, bei dem zunächst ein Grundkörper aus einem Mehrschichtaufbau aus mehreren piezoelektrischen Keramikschichten und Elektroden, welche in Form eines Stapels alternierend übereinanderliegend angeordnet sind, bereitgestellt wird, der Grundkörper anschließend gesintert und mit Außenelektroden versehen wird, bevor dann auf eine Oberfläche dieses Bauteils eine isolierende Glaspaste aufgebracht und einer Wärmebehandlung unterworfen wird.

Allerdings sind die mit den vorgenannten Verfahren erhältlichen piezoelektrischen Bauteile insbesondere in ihren inaktiven Randbereichen bruchanfällig und werden deshalb häufig als nachteilig empfunden.

Aufgabe der vorliegenden Erfindung ist es daher, ein Verfahren zum Herstellen eines piezoelektrischen Bauteils bereitzustellen, welches piezoelektrische Bauteile liefert, welche insbesondere in den inaktiven Randbereichen weniger bruchanfällig als die aus dem Stand der Technik bekannten piezoelektrischen Bauteile sind. Zudem sollen die mit dem erfindungsgemäßen Verfahren herstellbaren piezoelektrischen Bauteile auch bei hohen Temperaturen und gleichzeitig hohen Drücken gegenüber Treibstoff sowie Wasser undurchlässig und daher insbesondere zur Steuerung eines Einspritzventils in einem Dieselmotor geeignet sein.

Erfindungsgemäß wird diese Aufgabe gelöst durch ein Verfahren zum Herstellen eines piezoelektrischen Bauteils mit den Merkmalen des Patentanspruchs 1 und insbesondere\durch ein Verfahren zum Herstellen eines piezoelektrisches Bauteils, insbesondere eines Piezoaktor, mit wenigstens einer Außenfläche und umfassend einen Mehrschichtaufbau aus wenigstens einer piezoelektrischen Keramikschicht und wenigstens zwei Elektroden, umfassend die folgenden Schritte:
a) Bereitstellen eines Grundkörpers eines piezoelektrischen Bauteils aus einem Mehrschichtaufbau aus wenigstens einer piezoelektrischen Keramikschicht und wenigstens zwei Elektroden, wobei die wenigstens eine piezoelektrische Keramikschicht und die einzelnen Elektroden in Form eines Stapels alternierend übereinanderliegend angeordnet sind,
b) Abschleifen zweier sich gegenüberliegender Seitenflächen des Grundkörpers, bis sich die Enden der Elektroden bis an die Oberfläche der beiden Seitenflächen erstrecken und dort freiliegen,
c) Beschichten des Grundkörpers mit einem Passivierungsmaterial, welches zumindest teilweise aus Glas besteht,
d) Abschleifen der anderen zwei sich gegenüberliegenden Seitenflächen des Grundkörpers, die nicht in Schritt b) abgeschliffen wurden, wodurch das Passivierungsmaterial auf diesen beiden Seitenflächen wieder entfernt wird,
e) Durchführen einer ersten Polung unter Anlegen eines elektrischen Feldes zwischen der Deckfläche und Bodenfläche des Mehrschichtaufbaus,
f) Anbringen je einer Außenelektrode auf die beiden in Schritt d) abgeschliffenen Seitenflächen und
g) Durchführen einer zweiten Polung durch Anlegen von elektrischer Spannung an die beiden Außenelektroden.

Überraschenderweise konnte im Rahmen der vorliegenden Erfindung herausgefunden werden, dass, indem das piezoelektrische Bauteil während dessen Herstellung in zwei unterschiedlichen Schritten gepolt wird, um in dem Randbereich zumindest eine gewisse Orientierung der Kristallite zu erreichen, piezoelektrische Bauteile mit einer geringen Bruchanfälligkeit auch in den inaktiven Randbereichen erhalten werden können. Zudem eignet sich Glas, welches an sich spröde und bruchanfällig ist, hervorragend als Passivierungsmaterial für ein während dessen Betrieb Dimensionsänderungen unterliegendes piezoelektrisches Bauteil, insbesondere wenn sichergestellt wird, dass sich die Beschichtung aus Passivierungsmaterial während des Betriebs des piezoelektrischen Bauteils dauerhaft unter Kompression befindet. Zudem konnte im Rahmen der vorliegenden Erfindung herausgefunden werden, dass Glas nicht nur gegenüber Treibstoff und Feuchtigkeit chemisch resistent ist, sondern für diese Verbindungen, insbesondere auch bei den in Einspritzanlagen in Dieselmotoren herrschenden hohen Temperaturen und Drücken, hinreichend undurchlässig ist. Zudem weist eine Beschichtung aus Glas auch ausreichende dielektrische Eigenschaften auf, um eine gute elektrische Isolierung der damit beschichteten Oberflächen zu erreichen. Durch Beschichtung insbesondere derjenigen Seitenflächen eines Piezoaktors, an denen die Innenelektroden unterschiedlicher Polarität freiliegen, mit dem erfindungsgemäß einzusetzenden Passivierungsmaterial aus Glas kann somit eine hervorragende Isolierung piezoelektrischer Bauteile erreicht werden.

Vorteilhafte Ausführungsformen der vorliegenden Erfindung sind in der Beschreibung, den Zeichnungen und den Unteransprüchen beschrieben.

Um während des Betriebs des piezoelektrischen Bauteils eine Rissbildung in dem Passivierungsmaterial zu vermeiden, wird in Weiterbildung des Erfindungsgedankens vorgeschlagen, in dem erfindungsgemäßen Verfahren ein Passivierungsmaterial einzusetzen, das einen geringeren thermischen Ausdehnungskoeffizienten als das damit beschichtete piezoelektrische Bauteil aufweist. Dadurch wird gewährleistet, dass sich das Passivierungsmaterial auf dem Bauteil in Kompression befindet.

Insbesondere mit Passivierungsmaterialien, welche einen (bei 20°C gemessenen) thermischen Ausdehnungskoeffizienten von weniger als 10 x 10⁻⁶/K aufweisen, werden gute Ergebnisse erhalten. Bevorzugt beträgt der thermische Ausdehnungskoeffizient des in dem erfindungsgemäßen Verfahren einzusetzenden Passivierungsmaterials weniger als 7,5 x 10⁻⁶/K, besonders bevorzugt weniger als 5 x 10⁻⁶/K und ganz besonders bevorzugt weniger als 4 x 10⁻⁶/K.

Zudem hat es sich im Rahmen der vorliegenden Erfindung als vorteilhaft erwiesen, wenn das in dem Verfahren eingesetzte Passivierungsmaterial eine Glasübergangstemperatur von mindestens 250°C, bevorzugt von mindestens 350°C, besonders bevorzugt von mindestens 450°C und ganz besonders bevorzugt von mindestens 500°C aufweist.

Glasmaterialien, welche die vorgenannten Kriterien hervorragend erfüllen, sind insbesondere Borsilikatglas und Quarzglas. Aus diesem Grund ist es bevorzugt, dass das Passivierungsmaterial Borsilikatglas und/oder Quarzglas enthält. Besonders gute Ergebnisse werden erhalten, wenn das Passivierungsmaterial aus einer der vorgenannten Verbindungen oder aus einer Mischung beider vorgenannten Verbindungen besteht. Borsilikatgläser beispielsweise zeichnen sich durch einen niedrigen thermischen Ausdehnungskoeffizienten im Bereich von 3 x 10⁻⁶/K und durch eine hohe Widerstandsfähigkeit gegenüber Chemikalien, insbesondere gegenüber Treibstoff und Wasser auch bei hohen Temperaturen und Drücken, aus. Zudem weisen Borsilikatgläser mit 0,24 N/mm²K eine hervorragende Wärmebeständigkeit auf, so dass diese gegenüber Temperaturänderungen und thermischem Schock ausreichend widerstandsfähig sind. Ähnlich hervorragende Eigenschaften als Passivierungsmaterial hat nach den Erkenntnissen der vorliegenden Erfindung auch Quarzglas.

In Weiterbildung des Erfindungsgedankens wird vorgeschlagen, in dem Passivierungsmaterial Borsilikatglas vorzusehen, welches 65 bis 85 Gew.-% SiO₂, 5 bis 25 Gew.-% B₂O₃ und 0 bis 15 Gew.-% wenigstens einer aus der aus Na₂O, K₂O, CaO, MgO, Al₂O₃, PbO und beliebigen Kombinationen hiervon bestehenden Gruppe ausgewählten Verbindung enthält.

Insbesondere mit erdalkalimetallfreien Borsilikatgläsern, welche eine besonders hohe Widerstandsfähigkeit gegenüber Chemikalien sowie einen besonders geringen thermischen Ausdehnungskoeffizienten aufweisen, werden besonders gute Ergebnisse erhalten. Üblicherweise enthalten solche erdalkalimetallfreien Borsilikatgläser 12 bis 13 Gew.-% B₂O₃ und mindestens 80 Gew.-% SiO₂. Ein Beispiel für ein kommerziell erhältliches Borsilikatglas aus dieser Gruppe ist Duran^{®} von Schott, Mainz, Deutschland.

Beispielsweise eignet sich das erfindungsgemäße Verfahren zur Herstellung eines piezoelektrischen Bauteils, insbesondere eines Piezoaktors, umfassend einen Mehrschichtaufbau aus wenigstens zwei piezoelektrischen Keramikschichten und wenigstens zwei Innenelektroden, wobei die einzelnen piezoelektrischen Keramikschichten und die einzelnen Innenelektroden in Form eines Stapels alternierend übereinanderliegend angeordnet sind - in dem, ausgenommen von der oberen und unteren Randschicht des Stapels, jeweils eine piezoelektrische Keramikschicht von zwei Innenelektroden und jeweils eine Innenelektrode von zwei piezoelektrischen Keramikschichten umgeben ist - und sich die einzelnen Innenelektroden zumindest bereichsweise bis zu wenigstens einer der Seitenflächen des Bauteils erstrecken, bei dem zwecks Vermeidung eines elektrischen Kurzschlusses zwischen zwei benachbarten, voneinander durch eine piezoelektrische Keramikschicht getrennten Innenelektroden wenigstens eine der Seitenflächen, bis zu der sich die einzelnen Innenelektroden zumindest bereichsweise erstrecken, mit einem erfindungsgemäßen Passivierungsmaterial, welches zumindest teilweise aus Glas besteht, beschichtet ist.

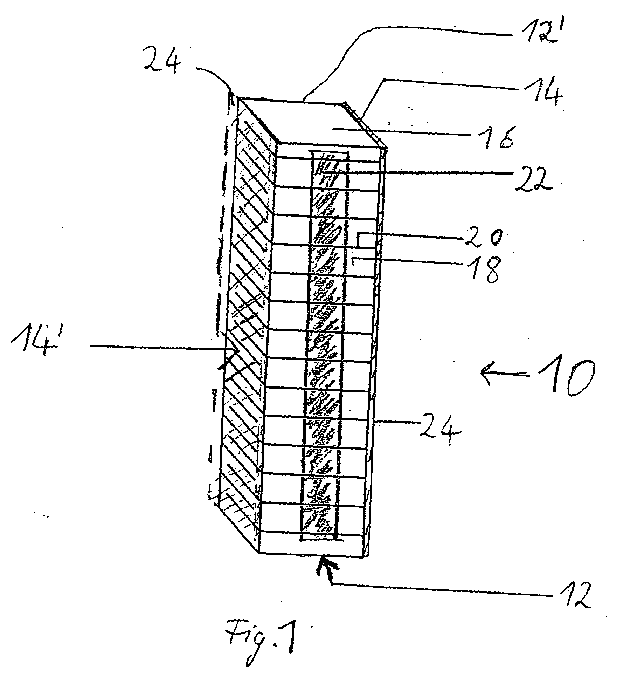

Üblicherweise weisen jeweils alternierende Innenelektroden eines piezoelektrischen Bauteils, insbesondere eines Piezoaktors, welcher - wie beispielsweise in der Figur 1 - gezeigt regelmäßig quaderförmig ausgebildet ist, unterschiedliche Polaritäten auf. Aus diesem Grund sind die erste, dritte, fünfte, siebte etc. Innenelektrode mit einer ersten, an einer ersten Seitenfläche des Bauteils angeordneten Außenelektrode, welche beispielsweise mit dem Pluspol einer Spannungsquelle verbunden ist, verbunden, wohingegen die zweite, vierte, sechste, achte etc. Innenelektrode mit einer zweiten, an der der ersten Seitenfläche gegenüberliegenden Seitenfläche angeordneten Außenelektrode, welche beispielsweise mit dem Minuspol einer Spannungsquelle verbunden ist, verbunden sind. Um einen elektrischen Kurzschluss zwischen den Außenelektroden und den im Vergleich dazu unterschiedlich gepolten Innenelektroden zu vermeiden, erstrecken sich die einzelnen Innenelektroden nicht über die gesamte Breite der durch die beiden jeweils eine Außenelektrode aufweisenden Seitenwände definierten Querschnittsebene, sondern von der Seitenfläche mit der Außenelektrode gleicher Polarität nur bis zu einem gewissen Abstand zu der gegenüberliegenden Seitenfläche des Bauteils. Dadurch bilden sich in den beiden Randbereichen der beiden Seitenflächen mit Außenelektroden piezoelektrisch inaktive Randbereiche aus, in denen jeweils nur Innenelektroden einer Polarität vorhanden sind. Hingegen erstrecken sich die Innenelektroden herkömmlicher piezoelektrischer Bauteile zwischen den beiden anderen Seitenflächen, welche keine Außenelektroden aufweisen, über die gesamte Breite der Querschnittsebene, so dass an den Oberflächen der entsprechenden Seitenflächen die Innenelektroden unterschiedlicher Polarität, nur durch eine dazwischen liegende piezoelektrische Keramikschicht voneinander getrennt, freiliegen. Um einen elektrischen Kurzschluss insbesondere an diesen Seitenflächen zuverlässig zu vermeiden, und zwar insbesondere auch bei hohen Temperaturen und/oder hohen Drücken, ist es bei dem erfindungsgemäßen Verfahren vorgesehen, wenigstens die beiden Seitenflächen, welche keine Außenelektrode aufweisen, mit einem Passivierungsmaterial zu beschichten, welches zumindest teilweise aus Glas besteht.

Das erfindungsgemäße Verfahren eignet sich insbesondere zur Herstellung von Common-Rail-Aktoren.

Insbesondere wenn das in dem erfindungsgemäßen Verfahren eingesetzte Passivierungsmaterial Borsilikatglas und/oder Quarzglas enthält bzw. aus Borsilikatglas und/oder aus Quarzglas besteht, werden aufgrund des geringen thermischen Ausdehnungskoeffizienten und der guten Widerstandsfähigkeit gegenüber Chemikalien der beiden vorgenannten Materialien beim Betrieb des Bauteils Rissbildungen in der Passivierungsschicht zuverlässig vermieden.

Dabei kann das Aufbringen des Passivierungsmaterials auf die wenigstens eine Außenfläche mit jedem dem Fachmann bekannten Verfahren erfolgen. Sofern das Passivierungsmaterial Quarzglas enthält oder aus Quarzglas besteht, erfolgt dies vorzugsweise durch Aufdampfen einer Silanverbindung auf die wenigstens eine Außenfläche des Bauteils bei einer Temperatur, bei der sich die Silanverbindung thermisch zu Siliziumdioxid zersetzt. Zu diesem Zweck können alle bekannten Silanverbindungen eingesetzt werden, die hinreichend thermisch instabil sind und sich bei entsprechenden Temperaturen zu Siliziumdioxid zersetzen. Lediglich beispielsweise seien Tetraalkoxysilane, Tetraalkylsilane und Dihalogensilane genannt. Bevorzugte Silanverbindungen sind insbesondere Tetraethoxysilan (TEOS) und Dichlorsilan.

Beim Aufdampfen der beiden letztgenannten Verbindungen auf die zu beschichtende Oberfläche des piezoelektrischen Bauteils bei beispielsweise 1.100°C zersetzt sich das TEOS bzw. Dichlorsilan gemäß den nachfolgenden Gleichungen zu Siliziumdioxid:

Si(C₂H₅O)₄-SiO₂ + 2H₂O + 4C₂H₄

2SiH₂Cl₂ + 2NO₂ → 2SiO₂ + 4HCl + N₂.

Ein Problem bei den herkömmlichen piezoelektrischen Bauteilen liegt darin, dass die Bauteile im Bereich der piezoelektrisch inaktiven Randbereiche bruchanfällig sind. Dies liegt darin begründet, dass in diesen Randbereichen nur Elektroden einer Polarität vorhanden sind, so dass bei der Polung in diesen Bereichen kein elektrisches Feld ausgebildet wird, weswegen die Kristallite in diesen Bereichen nicht gepolt sind. Ein Bruch in diesen Bereichen des piezoelektrischen Bauteils führt jedoch zwangsläufig auch zu einer mechanischen Beanspruchung der Beschichtung aus Passivierungsmaterial, was zu einer Rissbildung in dem Passivierungsmaterial führen kann. Diese Nachteile werden durch das erfindungsgemäße Verfahren überwunden.

Indem in Schritt e) bei der ersten Polung eine Spannung zwischen der Deck- und Bodenfläche des Mehrschichtaufbaus angelegt wird, bildet sich über die gesamte Querschnittsfläche des piezoelektrischen Bauteils, also auch insbesondere in den axialen Randbereichen der Seitenflächen, ein gleichmäßiges elektrisches Feld aus, wodurch auch die piezoelektrische Keramik in den Randbereichen zumindest zu einem gewissen Grad gepolt wird. So wird eine über die Querschnittsfläche des Bauteils gesehen gleichmäßigere Orientierung der Kristallite erreicht, so dass die Bruchanfälligkeit an den Randbereichen des piezoelektrischen Bauteils verringert wird. Die Durchführung der ersten und zweiten Polung gemäß den Merkmalen e) und g) ist detailliert in der WO 03/105247 beschrieben, die hiermit als Referenz eingeführt wird.

Vorzugsweise erfolgt die Anbringung der Außenelektroden auf die beiden Seitenflächen gemäß Schritt f) durch Metallabscheidung aus der Gasphase bei einer Temperatur unterhalb der Curie-Temperatur des piezoelektrischen Keramikmaterials. Diese Abscheidung kann beispielsweise mit der Sputtering-Technik oder durch Bogenverdampfung erfolgen.

Die zweite Polung gemäß Schritt g) des Verfahrens kann unmittelbar nach Anbringen der beiden Außenelektroden gemäß Schritt f) erfolgen oder aber auch zu einem späteren Zeitpunkt. Vorzugsweise wird die zweite Polung erst nach dem vollständigen Zusammenbau des piezoelektrischen Bauteils durchgeführt, da das Bauteil zu diesem Zeitpunkt am besten gegenüber schädlichen Einflüssen geschützt ist. Insbesondere hat es sich als vorteilhaft erwiesen, die zweite Polung hydrostatisch durchzuführen, um sicherzustellen, dass das gesamte Bauteil bei der zweiten Polung in Kompression verbleibt.

Im Falle eines Piezoaktors zur Verwendung in einer Einspritzanlage erfolgt die zweite Polung vorzugsweise nach dem Einbau des Piezoaktors in den Injektor.

Nachfolgend wird die vorliegende Erfindung rein beispielhaft anhand vorteilhafter Ausführungsformen und unter Bezugnahme auf die beigefügten Zeichnungen beschrieben.

Dabei zeigen:
- Fig. 1: eine perspektivische Ansicht eines Piezoaktors mit Passivierungsschichten und
- Fig. 2: ein Diagramm zeigend die Abhängigkeit der Dehnung eines piezoelektrischen Bauteils in Abhängigkeit von der Temperatur.

Der in der Fig. 1 schematisch dargestellte Piezoaktor 10 ist quaderförmig ausgebildet und umfasst vier Seitenflächen 12, 12', 14, 14', eine Bodenfläche und eine Deckfläche 16. Er besteht aus alternierend angeordneten Schichten aus piezoelektrischer Keramik 18 und Innenelektroden 20, wobei die einzelnen Schichten 18, 20 in Form eines Stapels übereinanderliegend angeordnet sind und - ausgenommen von der obersten und untersten Schicht - jeweils eine piezoelektrische Keramikschicht 18 von zwei Innenelektroden 20 und jede Innenelektrode 20 von jeweils zwei piezoelektrischen Keramikschichten 18 umgeben ist.

An den zwei gegenüberliegenden Seitenflächen 12, 12' des quaderförmigen Piezoaktors 10 ist jeweils eine aus einer Metallschicht bestehende Außenelektrode 22 vorgesehen. Die einzelnen Innenelektroden 20 sind von unten nach oben gesehen jeweils abwechselnd mit einer der beiden Außenelektroden 22 verbunden. So sind die von unten gesehen erste, dritte, fünfte etc. Innenelektrode 20 mit der an der Seitenfläche 12 aufgebrachten Außenelektrode 22 verbunden, wohingegen die zweite, vierte, sechste etc. Innenelektrode 20 mit der an der der Seitenfläche 12 gegenüberliegenden Seitenfläche 12' angeordneten Außenelektrode verbunden sind. Durch Anlegen einer elektrischen Spannung an die beiden Außenelektroden 22 können zwischen den einzelnen Innenelektroden 20 des piezoelektrischen Bauteils 10 elektrische Felder ausgebildet werden, wobei aufgrund der alternierenden Polaritäten der Innenelektroden 20 die einzelnen elektrischen Felder an zwei benachbarten piezoelektrischen Keramikschichten 18 jeweils unterschiedlich orientiert sind.

Um einen elektrischen Kurzschluss zwischen den einzelnen Innenelektroden 20 und den jeweils entgegengesetzt gepolten Außenelektroden 22 zu verhindern, erstrecken sich die einzelnen Innenelektroden 20 ausgehend von der jeweiligen Außenelektrode 22, mit der diese verbunden sind, nicht durchgehend bis zu der der entsprechenden Außenelektrode 22 gegenüberliegenden Seitenfläche 12, 12' mit der entgegengesetzt polarisierten Außenelektrode 22, sondern enden - wie auf der Seitenfläche 12' der Fig. 1 erkennbar - in einem gewissen Abstand hiervon. Aufgrund der alternierenden Anordnung der Innenelektroden 20 bilden sich daher an den Seitenflächen 12, 12' axial verlaufende Randbereiche aus, in denen jeweils nur Elektroden einer Polarität vorhanden sind.

Hingegen erstrecken sich die einzelnen Innenelektroden 20 in der durch die beiden anderen Seitenflächen 14, 14', welche nicht mit einer Außenelektrode 22 versehen sind, definierte Ebene durchgehend, so dass die einzelnen Innenelektroden 20 auf den Oberflächen der Seitenflächen 14, 14' freiliegen, wobei jeweils zwei benachbarte Innenelektroden 20 eine unterschiedliche Polarität aufweisen. Um einen elektrischen Kurzschluss zwischen den einzelnen auf den Oberflächen der Seitenflächen 14, 14' freiliegenden Innenelektroden 20 unterschiedlicher Polarität zu vermeiden, wird bei dem erfindungsgemäßen Verfahren auf den beiden Seitenflächen 14, 14' jeweils eine Beschichtung 24 aus Passivierungsmaterial, das zumindest teilweise aus Glas besteht, aufgebracht. Die Beschichtungen 24 auf den Seitenflächen 14, 14' sind in der Fig. 1 schraffiert und gestrichelt dargestellt.

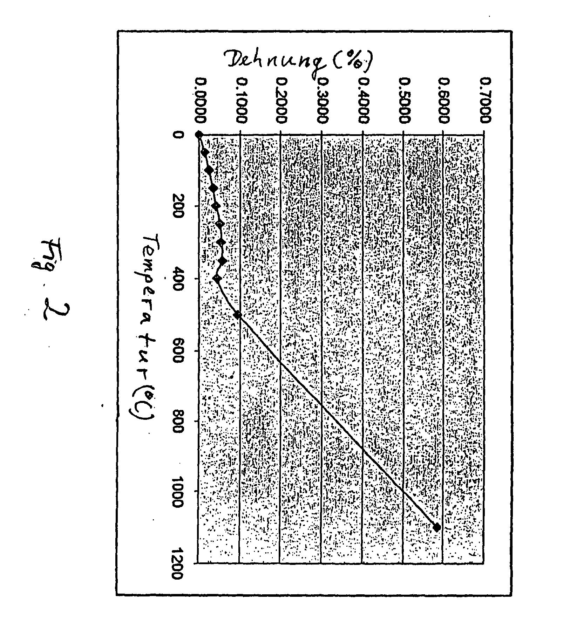

In der Fig. 2 ist die thermische Ausdehnung eines herkömmlichen, keine erfindungsgemäß aufzubringende Passivierungsschicht aufweisenden Piezoaktors 10 in Abhängigkeit von der Temperatur dargestellt. Wie sich dem Diagram entnehmen lässt, dehnt sich ein herkömmlicher Piezoaktor 10 beim Erwärmen von 0°C auf 1.100°C um 0,59 % aus bzw. kontrahiert beim Abkühlen von 1.100°C auf 0°C um denselben Faktor.

Im Vergleich zu dem Piezoaktor 10 weist das in dem erfindungsgemäßen Verfahren eingesetzte Passivierungsmaterial aus Glas einen signifikant geringeren thermischen Ausdehnungskoeffizienten auf, der beispielsweise für Borsilikatglas etwa 3 x 10⁻⁶/K beträgt. Sofern das Passivierungsmaterial bspw. durch Gasphasenabscheidung bei 1.100°C auf den Piezoaktor 10 aufgebracht wurde, erfährt die Glasbeschichtung beim Abkühlen von 1.100°C auf 0°C daher eine Stauchung von 0,59 %.

Während der Polung des Piezoaktor 10 beträgt die maximale Dehnung des Bauteils 10 entlang der Polungsachse etwa 0,2 %, wobei die remanente Dehnung nach der Polung etwa 0,11 % beträgt. Wenn nun eine erfindungsgemäß einzusetzende Beschichtung aus Glaspassivierungsmaterial bei 1.100°C auf die Seitenflächen 14, 14' des Piezoaktors 10 aufgetragen wurde, verbleibt die Glasbeschichtung aufgrund des unterschiedlichen thermischen Ausdehnungskoeffizienten während des gesamten Polungsprozesses unter Kompression und endet nach Abschluss des Polungsvorgangs bei einer Stauchung von etwa 0,48 % entsprechend der durch unterschiedlichen thermischen Ausdehnungskoeffizienten verursachten Dehnung abzüglich der nach der Polung verbleibenden remanenten Dehnung.

Während des Betriebs des Piezoaktors 10 in einer Einspritzanlage eines Dieselmotors unterliegt der Piezoaktor 10 einem Einspritzdruck, welcher sowohl die keramische Mehrschichtanordnung als auch die Glaspassivierungsschicht komprimiert. Bei 200 bar wird die Keramik um 0,023 % komprimiert, wohingegen die Kompression bei 2.000 bar etwa 0,23 % beträgt. Mithin unterliegt die Glaspassivierungsschicht auf einem gepolten Piezoaktor 10 bei 200 bar einer Stauchung von etwa 0,48 % und bei 2.000 bar einer Stauchung von etwa 0,71 %.

Wenn der mit der Passivierungsschicht beschichtete Piezoaktor 10 durch Anlegen einer entsprechenden elektrischen Spannung auf einen Stellweg bzw. Hub von 100 µm eingestellt wird, resultiert eine sich longitudinal erstreckende Dehnung von ungefähr 0,125 %, die signifikant geringer ist als die durch die unterschiedlichen thermischen Ausdehnungskoeffizienten und den Betriebsdruck verursachte Stauchung. Aufgrund dessen verbleibt die Passivierungsschicht bei allen Drücken in Kompression, wobei die Kompression durchschnittlich ungefähr 0,35 % beträgt. Dadurch werden Risse in der Passivierungsschicht 24 beim Betrieb des Piezoaktors 10 zuverlässig vermieden.

Zudem wird durch das erfindungsgemäß einzusetzende Passivierungsmaterial, welches zumindest teilweise aus Glas besteht, ein elektrischer Kurzschluss in einem piezoelektrischen Bauteil, insbesondere auf den Seitenflächen, auf denen Elektroden unterschiedlicher Polarität freiliegen, zuverlässig verhindert. Besonders vorteilhaft wirken sich in diesem Zusammenhang die gute Beständigkeit von Glas gegenüber Chemikalien, insbesondere Treibstoff und Wasser, und der geringe thermische Ausdehnungskoeffizient von Glas aus. Zudem lässt sich Glas auf einem piezoelektrischen Bauteil aufgrund dessen exzellenter Bindefähigkeit fest binden. Ferner erlaubt die vergleichsweise dünne Glasschicht einen effektiven Wärmetransport von dem piezoelektrischen Bauteil zu dem dieses umgebenden Medium, beispielsweise Treibstoff in einer Einspritzanlage.

### Bezugszeichenliste

- 10: Piezoaktor
- 12, 12': Seitenfläche mit Außenelektrode
- 14, 14': Seitenfläche ohne Außenelektrode
- 16: Deckfläche
- 18: piezoelektrische Keramik
- 20: Innenelektrode
- 22: Außenelektrode
- 24: Beschichtung aus Passivierungsmaterial

## Patentansprüche

1. Verfahren zum Herstellen eines piezoelektrischen Bauteils, insbesondere eines Piezoaktors (10), mit wenigstens einer Außenfläche (12, 12', 14, 14', 16) und umfassend einen Mehrschichtaufbau aus wenigstens einer piezoelektrischen Keramikschicht (18) und wenigstens zwei Elektroden (20, 22), umfassend die folgenden Schritte:
a) Bereitstellen eines Grundkörpers eines piezoelektrischen Bauteils aus einem Mehrschichtaufbau aus wenigstens einer piezoelektrischen Keramikschicht (18) und wenigstens zwei Elektroden (20), wobei die wenigstens eine piezoelektrische Keramikschicht (18) und die einzelnen Elektroden (20) in Form eines Stapels alternierend übereinanderliegend angeordnet sind,
b) Abschleifen zweier sich gegenüberliegender Seitenflächen (14, 14') des Grundkörpers, bis sich die Enden der Elektroden (20) bis an die Oberfläche der beiden Seitenflächen (14, 14') erstrecken und dort freiliegen,
c) Beschichten des Grundkörpers mit einem Passivierungsmaterial, welches zumindest teilweise aus Glas besteht,
d) Abschleifen der anderen zwei sich gegenüberliegenden Seitenflächen (12, 12') des Grundkörpers, die nicht in Schritt b) abgeschliffen wurden, wodurch das Passivierungsmaterial auf diesen beiden Seitenflächen (12, 12') wieder entfernt wird,
e) Durchführen einer ersten Polung unter Anlegen eines elektrischen Feldes zwischen der Deckfläche (16) und Bodenfläche des Mehrschichtaufbaus,
f) Anbringen je einer Außenelektrode (22) auf die beiden in Schritt d) abgeschliffenen Seitenflächen (12, 12') und
g) Durchführen einer zweiten Polung durch Anlegen von elektrischer Spannung an die beiden Außenelektroden (22).

2. Verfahren nach Anspruch 1,
**dadurch gekennzeichnet, dass**
ein Passivierungsmaterial mit einem geringeren thermischen Ausdehnungskoeffizienten als das damit beschichtete Bauteil eingesetzt wird.

3. Verfahren nach Anspruch 1 oder 2,
**dadurch gekennzeichnet, dass**
ein Passivierungsmaterial mit einem bei 20°C gemessenen thermische Ausdehnungskoeffizienten von weniger als 10 x 10⁻⁶/K, bevorzugt von weniger als 7,5 x 10⁻⁶/K, besonders bevorzugt von weniger als 5 x 10⁻⁶/K und ganz besonders bevorzugt von weniger als 4 x 10⁻⁶/K eingesetzt wird.

4. Verfahren nach einem der vorhergehenden Ansprüche,
**dadurch gekennzeichnet, dass**
ein Passivierungsmaterial mit einer Glasübergangstemperatur von mindestens 250°C, bevorzugt von mindestens 350°C, besonders bevorzugt von mindestens 450°C und ganz besonders bevorzugt von mindestens 500°C eingesetzt wird.

5. Verfahren nach einem der vorhergehenden Ansprüche,
**dadurch gekennzeichnet, dass**
ein Borsilikatglas und/oder Quarzglas enthaltendes oder aus Borsilikatglas und/oder Quarzglas bestehendes Passivierungsmaterial eingesetzt wird.

6. Verfahren nach Anspruch 5,
**dadurch gekennzeichnet, dass**
das Borsilikatglas 65 bis 85 Gew.-% SiO₂, 5 bis 25 Gew.-% B₂O₃ und 0 bis 15 Gew.-% wenigstens einer aus der aus Na20, K₂O, CaO, MgO, Al₂O₃, PbO und beliebigen Kombinationen hiervon bestehenden Gruppe ausgewählten Verbindung enthält.

7. Verfahren nach einem der vorherigen Ansprüche,
**dadurch gekennzeichnet, dass**
ein Passivierungsmaterial enthaltend Quarzglas oder bestehend aus Quarzglas eingesetzt wird und der Grundkörper in Schritt c) durch Aufdampfen einer Silanverbindung mit dem Quarzglas beschichtet wird.

8. Verfahren nach Anspruch 7,
**dadurch gekennzeichnet, dass**
als Silanverbindung ein Tetraalkoxysilan, ein Tetraalkylsilan und/oder ein Dihalogensilan eingesetzt wird.

9. Verfahren nach Anspruch 7 oder 8,
**dadurch gekennzeichnet, dass**
als Silanverbindung Tetraethoxysilan und/oder Dichlorsilan eingesetzt wird.

10. Verfahren nach einem der vorherigen Ansprüche,
**dadurch gekennzeichnet, dass**
die Anbringung der Außenelektroden (22) auf die beiden Seitenflächen (12, 12') gemäß Schritt f) durch Metallabscheidung aus der Gasphase bei einer Temperatur unterhalb der Curie-Temperatur des piezoelektrischen Keramikmaterials (18) erfolgt.

11. Verfahren nach Anspruch 10,
**dadurch gekennzeichnet, dass**
die Abscheidung mittels Sputtering-Technik oder durch Bogenverdampfung erfolgt.

12. Verfahren nach einem der vorherigen Ansprüche,
**dadurch gekennzeichnet, dass**
die zweite Polung gemäß Schritt g) unmittelbar nach Anbringen der beiden Außenelektroden (22) gemäß Schritt f) oder bevorzugt nach dem vollständigen Zusammenbau des piezoelektrischen Bauteils (10) durchgeführt wird.

## Claims

1. Process for producing a piezoelectric component, in particular a piezo-actuator (10), having at least one outer surface (12, 12', 14, 14', 16) and comprising a multi-layered structure of at least one piezoelectric ceramic layer (18) and at least two electrodes (20, 22), comprising the following steps:
a) provision of a base body of a piezoelectric component made of a multi-layered structure of at least one piezoelectric ceramic layer (18) and at least two electrodes (20), wherein the at least one piezoelectric ceramic layer (18) and the individual electrodes (20) are arranged alternately lying one above another in the form of a stack ,
b) grinding two opposing side surfaces (14, 14') of the base body until the ends of the electrodes (20) extend as far as the surface of the two side surfaces (14, 14') and are exposed there,
c) coating the base body with a passivating material which consists at least partly of glass,
d) grinding the other two opposing side surfaces (12, 12') of the base body which have not been ground in step b), as a result of which the passivating material is removed again on these two side surfaces (12, 12'),
e) carrying out a first polarisation while applying an electric field between the top surface (16) and base surface of the multi-layered structure,
f) attaching in each case an external electrode (22) to the two side surfaces (12, 12') ground in step d) and
g) carrying out a second polarisation by applying electrical voltage to the two external electrodes (22).

2. Process according to claim 1, **characterised in that** a passivating material having a lower coefficient of thermal expansion than the component coated therewith is used.

3. Process according to claim 1 or 2, **characterised in that** a passivating material having a coefficient of thermal expansion measured at 20°C of less than 10 x 10⁻⁶/K, preferably of less than 7.5 x 10⁻⁶/K, particularly preferably of less than 5 x 10⁻⁶/K and most particularly preferably of less than 4 x 10⁻⁶/K is used.

4. Process according to one of the preceding claims, **characterised in that** a passivating material having a glass transition temperature of at least 250°C, preferably of at least 350°C, particularly preferably of at least 450°C and most particularly preferably of at least 500°C is used.

5. Process according to one of the preceding claims, **characterised in that** a passivating material containing borosilicate glass and/or quartz glass or consisting of borosilicate glass and/or quartz glass is used.

6. Process according to claim 5, **characterised in that** the borosilicate glass contains 65 to 85 wt.% of SiO₂, 5 to 25 wt.% of B₂O₃ and 0 to 15 wt.% of at least one compound selected from the group consisting of Na₂O, K₂O, CaO, MgO, Al₂O₃, PbO and any combinations thereof.

7. Process according to one of the previous claims, **characterised in that** a passivating material containing quartz glass or consisting of quartz glass is used and the base body is coated with the quartz glass in step c) by evaporation coating of a silane compound.

8. Process according to claim 7, **characterised in that** a tetraalkoxysilane, a tetraalkylsilane and/or a dihalogensilane is used as the silane compound.

9. Process according to claim 7 or 8, **characterised in that** tetraethoxysilane and/or dichlorosilane is used as the silane compound.

10. Process according to one of the previous claims, **characterised in that** the attachment of the external electrodes (22) to the two side surfaces (12, 12') according to step f) is effected by metal deposition from the gas phase at a temperature below the Curie temperature of the piezoelectric ceramic material (18).

11. Process according to claim 10, **characterised in that** the deposition is effected by means of sputtering technology or by arc evaporation.

12. Process according to one of the previous claims, **characterised in that** the second polarisation according to step g) is carried out immediately after attaching the two external electrodes (22) according to step f) or preferably after the complete assembly of the piezoelectric component (10).

## Revendications

1. Procédé pour la fabrication d'un composant piézo-électrique, en particulier d'un piézo-actionneur (10), avec au moins une face extérieure (12, 12', 14, 14', 16) et comprenant une structure multicouche composée d'au moins une couche céramique piézo-électrique (18) et d'au moins deux électrodes (20, 22), comprenant les étapes suivantes :
a) préparation d'un corps de base d'un composant piézo-électrique à partir d'une structure multicouche composée d'au moins une couche céramique piézo-électrique (18) et d'au moins deux électrodes (20), dans lequel ladite au moins une couche céramique piézo-électrique (18) et les électrodes individuelles (20) sont agencées en alternance les unes au-dessus des autres sous la forme d'une pile,
b) meulage de deux faces latérales opposées (14, 14') du corps de base, jusqu'à ce que les extrémités des électrodes (20) s'étendent jusqu'à la surface des deux faces latérales (14, 14') et s'y trouvent à découvert,
c) revêtement du corps de base avec un matériau de passivation, lequel est au moins partiellement constitué de verre,
d) meulage des deux autres faces latérales opposées (12, 12') du corps de base, qui n'ont pas été meulées à l'étape b), grâce à quoi le matériau de passivation est à nouveau enlevé de ces deux faces latérales (12, 12'),
e) exécution d'une première polarisation en appliquant un champ électrique entre la surface de couverture (16) et la surface de fond de la structure multicouche,
f) application d'une électrode extérieure respective (22) sur les deux faces latérales (12, 12') meulées à l'étape d), et
g) exécution d'une seconde "polarisation" en appliquant une tension électrique aux deux électrodes extérieures (22).

2. Procédé selon la revendication 1,
**caractérisé en ce que** l'on emploie un matériau de passivation avec un coefficient de dilatation thermique plus faible que le composant revêtu avec ce matériau.

3. Procédé selon la revendication 1 ou 2,
**caractérisé en ce que** l'on emploie un matériau de passivation avec un coefficient de dilatation thermique mesuré à 20°C inférieur à 10 x 10⁻⁶/K, de préférence inférieur à 7,5 x 10⁻⁶/K, de façon particulièrement préférée inférieur à 5 x 10⁻⁶/K, et de façon tout particulièrement préférée inférieur à 4 x 10⁻⁶/K.

4. Procédé selon l'une des revendications précédentes,
**caractérisé en ce que** l'on emploie un matériau de passivation avec une température de transition vitreuse d'au moins 250°C, de préférence d'au moins 350°C, de façon particulièrement préférée d'au moins 450°C, et de façon tout particulièrement préférée d'au moins 500°C.

5. Procédé selon l'une des revendications précédentes,
**caractérisé en ce que** l'on emploie un matériau de passivation contenant du verre borosilicate et/ou du verre de quartz ou constitué de verre borosilicate et/ou de verre de quartz.

6. Procédé selon la revendication 5,
**caractérisé en ce que** le verre borosilicate contient de 65 à 85 % en poids de SiO₂, de 5 à 25 % en poids de B₂O₃, et de 0 à 15 % en poids d'au moins un composé choisi parmi le groupe formé de Na₂O, K₂O, CaO, MgO, Al₂O₃, PbO, et de combinaisons quelconques de ces produits.

7. Procédé selon l'une des revendications précédentes,
**caractérisé en ce que** l'on emploie un matériau de passivation contenant du verre de quartz ou constitué de verre de quartz, et **en ce que** le corps de base est revêtu avec le verre de quartz à l'étape c) par vaporisation d'un composé au silane.

8. Procédé selon la revendication 7,
**caractérisé en ce que** l'on emploie comme composé au silane un tétraalcoxysilane, un tétraalkylsilane, et/ou un dihalogénosilane.

9. Procédé selon la revendication 7 ou 8,
**caractérisé en ce que** l'on emploie comme composé au silane du tétraéthoxysilane et/ou du dichlorosilane.

10. Procédé selon l'une des revendications précédentes,
**caractérisé en ce que** l'application des électrodes extérieures (22) sur les deux faces latérales (12, 12') selon l'étape f) a lieu par précipitation de métal à partir d'une phase gazeuse à une température au-dessous de la température de Curie du matériau céramique piézo-électrique (18).

11. Procédé selon la revendication 10,
**caractérisé en ce que** la précipitation a lieu au moyen d'une technique de "sputtering", ou par vaporisation à l'arc.

12. Procédé selon l'une des revendications précédentes,
**caractérisé en ce que** la seconde polarisation selon l'étape g) est exécutée immédiatement après l'application des deux électrodes extérieures (22) selon l'étape f), ou de préférence après assemblage complet du composant piézo-électrique (10).
